# EUROPEAN PATENT SPECIFICATION

(11) **EP 3 168 881 B1**
(45) Date of publication and mention of the grant of the patent: **22.09.2021**
(21) Application number: 16190076.6
(22) Date of filing: 22.09.2016
(51) Int. Cl.: H01L 27/32

(54) **OLED PANEL, TERMINAL AND METHOD FOR CONTROLLING PHOTOSENSITIVITY**
OLED-PANEL, ENDGERÄT UND VERFAHREN ZUR STEUERUNG DER LICHTEMPFINDLICHKEIT
PANNEAU À AFFICHAGE ÉLECTROLUMINESCENT ORGANIQUE, TERMINAL ET PROCÉDÉ DE RÉGULATION DE LA PHOTOSENSIBILITÉ

(30) Priority: 13.11.2015 CN 201510779976
(43) Date of publication of application: 17.05.2017
(73) Proprietor: Xiaomi Inc., Beijing 100085 (CN)
(72) Inventor: LI, Guosheng, Beijing, 100085 (CN); ZHONG, Guilin, Beijing, 100085 (CN); FENG, Wei, Beijing, 100085 (CN)
(74) Representative: Hughes, Andrea Michelle

(56) References cited:
- US-A- 6 040 810
- US-A1- 2001 052 597
- US-A1- 2007 236 428
- US-A1- 2010 201 275

## Description

### TECHNICAL FIELD

The present disclosure relates to the field of display technology, and more particularly to an organic light emitting display (OLED) panel, a terminal and a method for controlling photosensitivity.

### BACKGROUND

A camera is a common component in a mobile terminal. The camera is used for collecting an image. The camera may be classified as a front-facing camera or a rear-facing camera in accordance with a determined position of the mobile terminal.

Taking the front-facing camera as an example, a front panel of the mobile terminal includes an OLED panel region and a frame region. In the related art, the frame region is provided with an aperture in which the front-facing camera is installed. The documents US2010/201275A, US2007/236428A and US2001/052597A are relevant prior art disclosures.

### SUMMARY

In order to resolve a problem that a terminal needs to be provided with a separate aperture for a camera, the present disclosure provides in embodiments an organic light emitting display (OLED) panel, a terminal and a method for controlling photosensitivity. The technical solutions are shown as below.

According to a first aspect of embodiments of the present disclosure, there is provided an organic light emitting display (OLED) panel as recited in claim 1. Further advantageous embodiments are recited in the dependent claims and the invention, irrespective of the content of the remainder of this description, is solely as defined by the appended claims. Irrespective of the content of the rest of the description the invention is solely as recited in the claims.

### BRIEF DESCRIPTION OF THE DRAWINGS

The accompanying drawings, which are incorporated in and constitute a part of this specification, illustrated embodiments consistent with the present disclosure and, together with the description, serve to explain the principles of the present disclosure.
Fig. 1 is a schematic diagram showing an OLED panel in the related art;
Fig. 2 is a schematic diagram showing an arrangement of pixel units of an array substrate;
Fig. 3A is a schematic diagram showing an OLED panel according to an illustrative embodiment of the present disclosure;
Fig. 3B is a schematic diagram showing an OLED panel according to another illustrative embodiment of the present disclosure;
Fig. 4A is a schematic diagram showing a position at which a photosensitive device is located according to an illustrative embodiment of the present disclosure;
Fig. 4B is a schematic diagram showing a position at which a photosensitive device is located according to an illustrative embodiment of the present disclosure;
Fig. 4C is a schematic diagram showing a position at which a photosensitive device is located according to an illustrative embodiment of the present disclosure;
Fig. 4D is a schematic diagram showing a position at which a photosensitive device is located according to another illustrative embodiment of the present disclosure;
Fig. 5 is a schematic diagram showing a control circuit according to an illustrative embodiment of the present disclosure;
Fig. 6A is a schematic diagram showing a Liquid Crystal Display (LCD) panel according to an illustrative embodiment of the present disclosure;
Fig. 6B is a schematic diagram showing an LCD panel according to an illustrative embodiment of the present disclosure;
Fig. 7 is a block diagram showing a terminal according to an illustrative embodiment of the present disclosure; and
Fig. 8 is a flow chart showing a method for controlling photosensitivity according to an illustrative embodiment of the present disclosure.

### DETAILED DESCRIPTION

Reference will now be made in detail to illustrative embodiments, examples of which are illustrated in the accompanying drawings. The following description refers to the accompanying drawings in which the same numbers in different drawings represent the same or similar elements unless otherwise represented. The implementations set forth in the following description of illustrative embodiments do not represent all implementations consistent with the invention. Instead, they are merely examples of apparatuses and methods consistent with aspects related to the invention as recited in the appended claims.

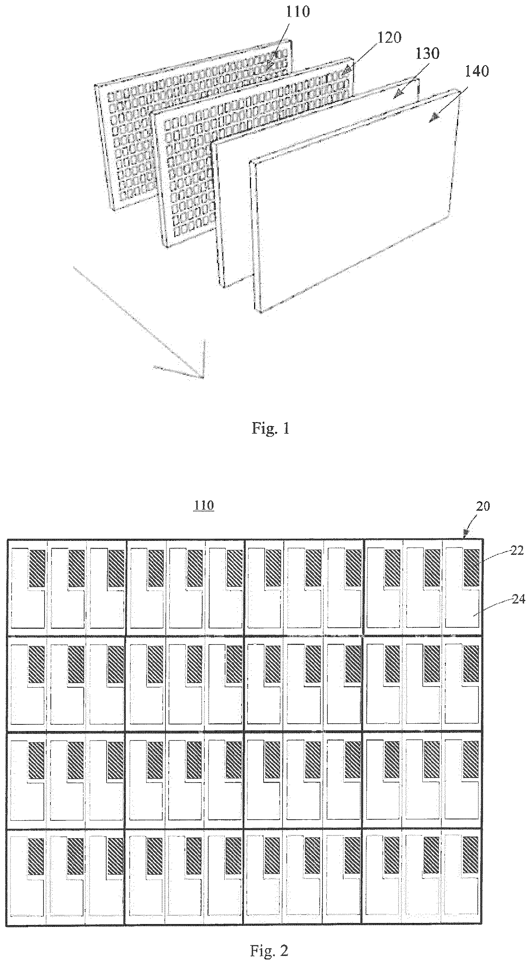

Before introducing and describing embodiments of the present disclosure, an organic light emitting display (OLED) panel is described briefly at first. Fig. 1 is a schematic diagram showing an OLED panel in the related art.

As shown in Fig. 1, the OLED panel includes: an array substrate 110, an OLED layer 120, a glass substrate 130 and a polarizer 140.

The OLED layer 120 is disposed on the array substrate 110, the glass substrate 130 is disposed on the OLED layer 120 and the polarizer 140 is disposed on the glass substrate 130.

The OLED layer 120 includes *m*×*n* pixel units. Each pixel unit includes *K* pixel sub-units. In general, each pixel unit in the OLED layer 120 includes three pixel sub-units, which are a red (R) pixel sub-unit, a green (G) pixel sub-unit and a blue (B) pixel sub-unit. In some embodiments, each pixel unit includes four pixel sub-units, which are a red (R) pixel sub-unit, a green (G) pixel sub-unit, a blue (B) pixel sub-unit and a white (W) pixel sub-unit. That is the number of *K* may be three or four.

Correspondingly, the array substrate 110 also includes *m*×*n* pixel units, corresponding to the *m*×*n* pixel units in the OLED layer 120. Each pixel units in the array substrate 110 includes *K* pixel sub-units, such as three or four.

Fig. 2 is a schematic diagram showing an arrangement of pixel units in the array substrate 110. As shown in Fig. 2, the array substrate 110 includes 4×4 pixel units, i.e., 16 pixel units, and each pixel unit includes three pixel sub-units 20. Each pixel sub-unit 20 includes a thin film transistor (TFT) region 22 and a non-TFT region 24.

It should be noted that, Fig. 2 merely shows a partial region of the array substrate 110, i.e., the array substrate 110 may consist of a plurality of regions as shown in Fig. 2. The arrangement as shown in Fig. 2 is merely illustrative and explanatory, and other arrangements are not defined in embodiments of the present disclosure.

The polarizer 140 is attached on the glass substrate 130.

The array substrate 110 provides the OLED layer 120 electric field, under which an organic semiconductor material and a light emitting material are driven to emit light, such that the light emitted passes through the glass substrate 130 and the polarizer 140 successively from bottom to top, thereby displaying an image.

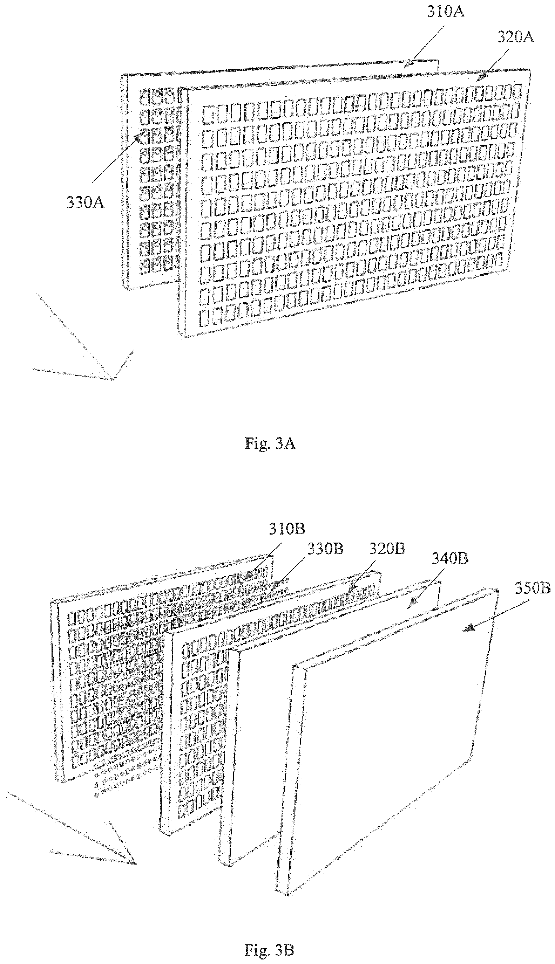

Fig. 3A is a schematic diagram showing an OLED panel according to an illustrative embodiment of the present disclosure. The OLED panel may be used for an electric device such as a mobile phone, a tablet computer and a laptop computer. As shown in Fig. 3A, the OLED panel includes:
an array substrate 310A;
an OLED layer 320A disposed on the array substrate 310A;
a photosensitive device array 330A disposed in the array substrate 310A; and
a control circuit (not shown) connected to the photosensitive device array 330A.

The glass substrate and the polarizer (not shown) may be disposed on the OLED layer 320A, as shown in Fig. 1.

Above all, with the OLED panel according to embodiments of the present disclosure, the photosensitive device array 330A is disposed in the array substrate 310A of the OLED panel, so as to solve a problem that a front panel is generally divided into a plurality of regions, so that a camera function is integrated into the OLED panel, such that a front panel of the terminal may have the displaying function and the camera function at the same time even if merely provided with the OLED panel, thereby enhancing integral consistency and aesthetics of the terminal.

Fig. 3B is a schematic diagram showing an OLED panel according to another illustrative embodiment of the present disclosure. The OLED panel may be used for an electric device such as a mobile phone, a tablet computer and a laptop computer. As shown in Fig. 3B, the OLED panel includes:
an array substrate 310B;
an OLED layer 320B disposed on the array substrate 310B;
a photosensitive device array 330B disposed between the array substrate 310B and the OLED layer 320B; and
a control circuit (not shown) connected to the photosensitive device array 330B.

A glass substrate 340B and a polarizer 350B may be disposed on the OLED layer 320B.

Above all, with the OLED panel according to embodiments of the present disclosure, the photosensitive device array 330B is disposed between the array substrate 310B and the OLED layer 320B, so as to solve a problem that a front panel usually is divided into a plurality of regions, so that a camera function is integrated into the OLED panel, such that a front panel of the terminal may have the displaying function and the camera function at the same time even if merely provided with the OLED panel, thereby enhancing integral consistency and aesthetics of the terminal.

In an alternative embodiment provided by the embodiment as shown in Fig. 3A, the photosensitive device array 330A includes *a*×*b* photosensitive devices. Each photosensitive device corresponds to one pixel sub-unit in the array substrate 310A, in which *a≤K*×*m* and *b≤n.* In a front view of the OLED panel, each photosensitive device is of a cross-section area less than an area occupied by one pixel sub-unit. During collecting the image, each photosensitive device is used to collect a photosensitive signal for one pixel sub-unit.

The number of photosensitive devices may be the following two cases.
1. The number of the photosensitive devices equals to the number of the pixel sub-units in the array substrate, i.e., *a*=*K*×*m* and *b*=*n.*
2. The number of the photosensitive devices is less than the number of the pixel sub-units in the array substrate, i.e., *a<K*×*m* and *b<n;* or *a<K*×*m* and *b*=*n;* or *a*=*K*×*m* and *b<n.*

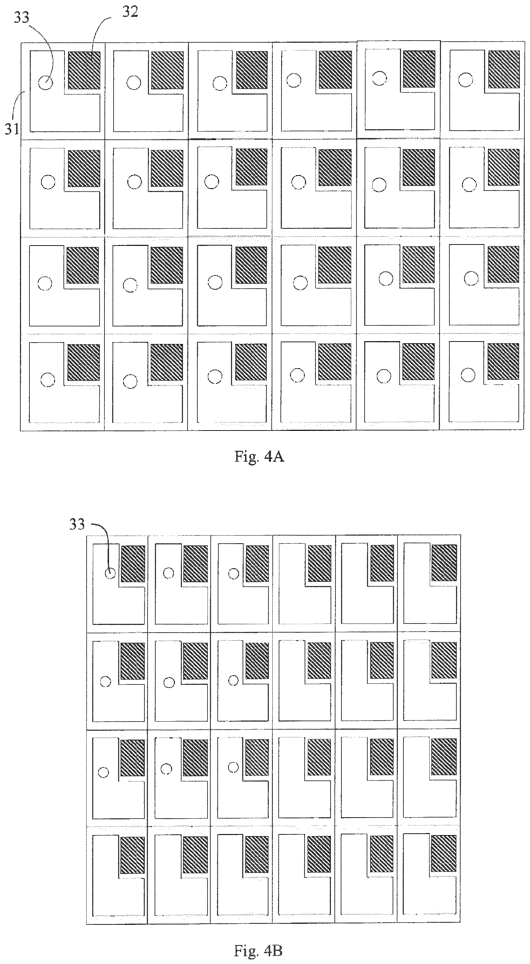

In accordance with different numbers of the photosensitive devices, the illustratively shown position where the photosensitive device is located may be the following cases.
1. The photosensitive devices in the photosensitive device array correspond to the pixel sub-units in the array substrate in a one-to-one manner, in which *a*=*K*×*m* and *b*=*n,* i.e., each pixel sub-unit corresponds to one photosensitive device.
   A position in which at least one photosensitive device is present is located at the non-TFT region of a corresponding pixel sub-unit.
   In general, in view of sizes of the photosensitive device and a circuit connected thereto, the position in which the photosensitive device is present is located at the non-TFT region of the corresponding pixel sub-unit; while in some embodiments, the position in which the photosensitive device is present is located at the TFT region of the corresponding pixel sub-unit.
   Taking the photosensitive device array disposed in the array substrate as an example, as shown in Fig. 4A, the array substrate includes 2×4 pixel units 31, i.e., includes 24 (8×3) pixel sub-units. The array substrate further includes 6×4 photosensitive devices 33, i.e., 24 photosensitive devices 33. The non-TFT region of each pixel sub-unit 31 is provided with one corresponding photosensitive device 33.
2. The photosensitive device array is located at a partial region of the array substrate, the photosensitive devices in the photosensitive device array correspond to the pixel sub-units in the partial region in a one-to-one manner, in which *a<K*×*m* and *b<n;* or *a* <*K*×*m* and *b*=*n;* or *a*=*K*×*m* and *b<n,* i.e., each pixel sub-unit in the partial region of the array substrate corresponds to one photosensitive device.
   Optionally, a position in which at least one photosensitive device is present is located at the non-TFT region of the corresponding pixel sub-unit.
   Taking the photosensitive device array disposed in the array substrate as an example, as shown in Fig. 4B, the array substrate includes 2×4 pixel units, i.e., includes 24 (8×3) pixel sub-units. The array substrate further includes 9 (3×3) photosensitive devices. For 9 pixel sub-units located at the partial region, each pixel sub-unit is provided with one corresponding photosensitive device 33.
3. The entire region of the array substrate is provided with the photosensitive devices corresponding to some pixel sub-units in the array substrate, which are arranged separately, in which *a<K*×*m* and *b<n;* or *a<K*×*m, b*=*n;* or *a*=*K*×*m* and *b<n.*

Optionally, a position in which at least one photosensitive device is present is located at the non-TFT region of the corresponding pixel sub-unit.

The photosensitive devices correspond to some pixel sub-units in the array substrate, i.e., the photosensitive devices are distributed in the entire region of the array substrate evenly. However, some pixel sub-units are provided with one photosensitive device, while other sub-pixel units are not provided with the photosensitive device.

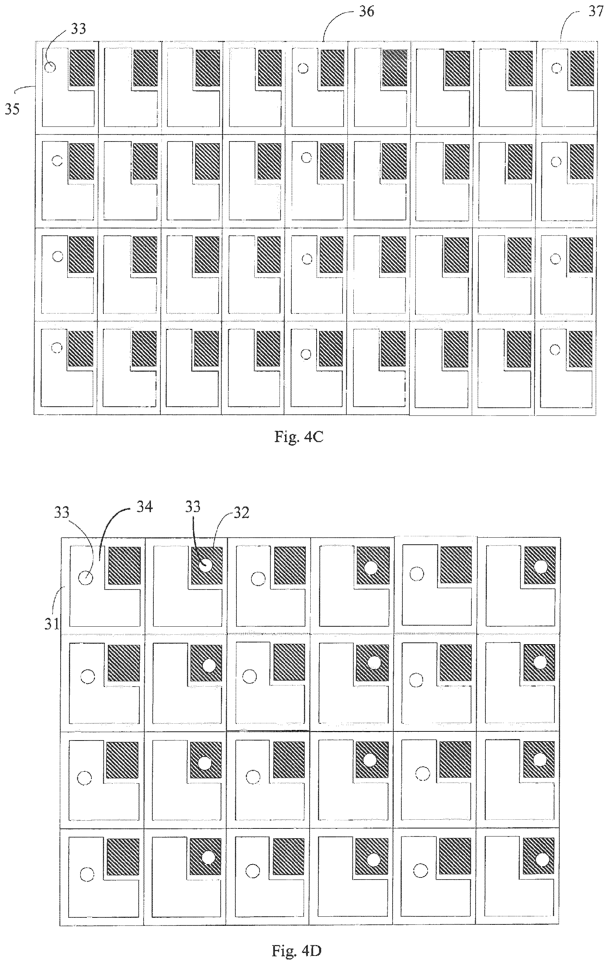

Taking the photosensitive device array disposed in the array substrate as an example, as shown in Fig. 4C, the array substrate includes 12 (3×4) pixel units 31, i.e., includes 36 (12×3) pixel sub-units. The array substrate further includes 3×4 photosensitive devices 33, i.e., 12 photosensitive devices 33. Taking the first row of the array substrate as an example, the first pixel sub-unit 35 in the first pixel unit from left to right side is provided with one photosensitive device 33, the second pixel sub-unit 36 in the second pixel unit is provided with one photosensitive device 33, and the third pixel sub-unit 37 in the third pixel unit is provided with one photosensitive device 33.

The photosensitive device array is further disposed between the array substrate and the OLED layer: the position in which the photosensitive device is present is located above the corresponding pixel sub-unit.

In the case that the photosensitive device array is disposed between the array substrate and the OLED layer, the position in which the photosensitive device is present is located above the corresponding pixel sub-unit, i.e., the position in which the photosensitive device is present is located above the TFT region of the corresponding pixel sub-unit, or above the non-TFT region of the corresponding pixel sub-unit.

Taking the photosensitive device array disposed between the array substrate and the OLED layer as an example, as shown in Fig. 4D, some photosensitive devices 33 are located above the TFT region 32 of the corresponding pixel sub-unit, and other photosensitive devices 33 are located above the non-TFT region 34 of the corresponding pixel sub-unit.

It should be noted that Figs. 4A-4D are merely some examples showing some positions in which the photosensitive device may be located, it is apparent for those skilled in the art to acquire other positions in which the photosensitive device is located based on combinations of the above described cases, and other possible arrangements of positions are not limited herein by embodiments of the present disclosure.

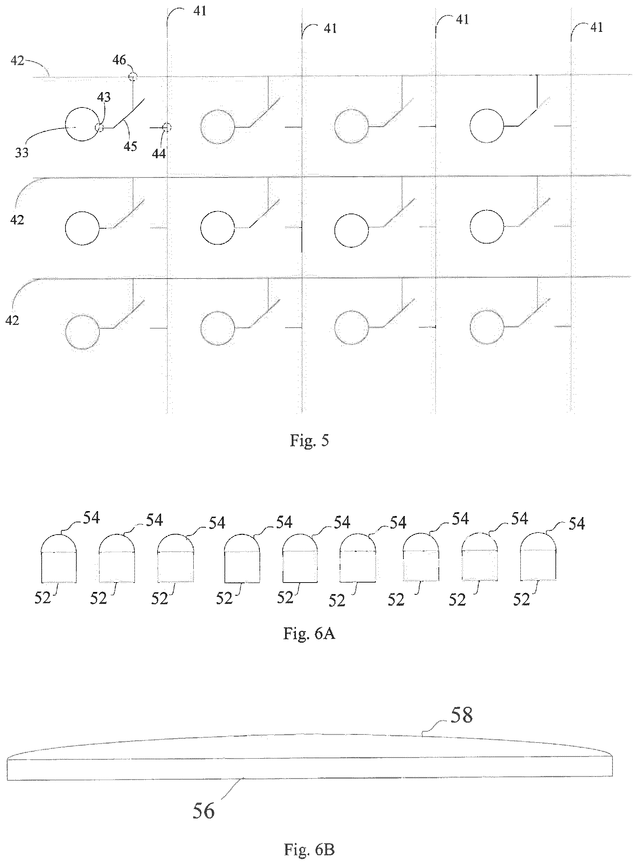

Fig. 5 is a schematic diagram showing a control circuit connected to a photosensitive device array. The control circuit includes: a plurality of data lines 41 in *a* columns and a plurality of control lines 42 in *b* rows.

Each row of the plurality of the control lines 42 is connected to the plurality of the data lines 41 in *a* columns via a number *a* switches 45 respectively. Each switch 45 includes: a control terminal 46 connected to the control line 42; a first connecting terminal 43 connected to the corresponding photosensitive device 33; and a second connecting terminal 44 connected to the corresponding data line 41.

As shown in Fig. 5, it is assumed that the control circuit includes three rows of the control lines 42, four columns of the data lines 41, 3×4 photosensitive devices, i.e., 12 photosensitive devices. Data in Fig. 5 is merely for illustration, the specific number of *a* or *b* is not limited herein.

As known to those skilled in the art, the array substrate may also include: *K*×*m* columns of the pixel data lines and *n* rows of the pixel control lines. The pixel data line and the pixel control line are connected to the pixel sub-unit via a TFT device. A control circuit consisting of the pixel data line and the pixel control line for connecting the TFT in the array substrate is similar to that shown in Fig. 4, which is not elaborated in detail herein.

Alternative embodiments are provided in accordance with the embodiments of Figs. 3A and 3B. A lens is disposed at a photosensitive side of each photosensitive device, i.e., the number of the lens equals to the number of the photosensitive devices. As shown in Fig. 6A, a lens 54 is disposed on each photosensitive device 52.Optionally, the lens 54 is a semi-lens with a convex surface.

The lens may be disposed at the photosensitive side of the photosensitive device array, i.e., one lens is disposed on the photosensitive device array and the lens can cover all photosensitive devices. As shown in Fig. 6B, one lens 58 is disposed at the photosensitive side of the photosensitive device array 56. Optionally, the lens 58 is a semi-lens with a convex surface. Optionally, the lens 58 is disposed on an upper polarizer as shown in Fig. 1.

In the present embodiment, the lens is disposed at the photosensitive side of the photosensitive device or the photosensitive side of the photosensitive device array, so that the photosensitive device may be of a wider photosensitive range, thereby achieving better effect of acquired image.

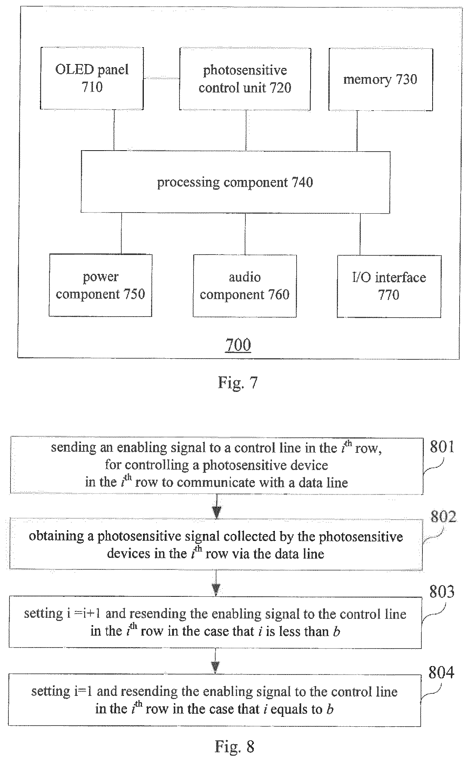

Fig. 7 is a block diagram showing a terminal according to an illustrative embodiment of the present disclosure. As shown in Fig. 7, the terminal 700 includes an OLED panel 710, a photosensitive control unit 720, a memory 730, a processing component 740, a power component 750, an audio component 760, an input/output (I/O) interface 770.

The OLED panel 710 may be any one of the OLED panels as shown in Figs. 3A, 3B, 6A and 6B provided by the above embodiments.

The photosensitive control unit 720 is connected to a control circuit in the OLED panel 710. The photosensitive control unit 720 is connected to each data line in the control circuit, and further connected to each control line in the control circuit. The control circuit is connected to the photosensitive device array in the OLED panel 710.

The memory 730 is configured to store various types of data for supporting operations to the device 700. Examples of such data include instructions for any applications or methods operated on the device 700, contact data, phonebook data, messages, pictures, video, etc. The memory 730 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The processing component 740 typically controls overall operations of the device 700, such as the operations associated with display, telephone calls, data communications, camera operations, and recording operations. The processing component 740 may include one or more processors to execute instructions to perform all or part of the steps in the above described methods. Moreover, the processing component 740 may include one or more modules which facilitate the interaction between the processing component 740 and other components.

The power component 750 provides power to various components of the device 700. The power component 750 may include a power management system, one or more power sources, and any other components associated with the generation, management, and distribution of power in the device 700.

The audio component 760 is configured to output and/or input audio signals. For example, the audio component 760 includes a microphone (MIC) configured to receive an external audio signal when the device 700 is in an operation mode, such as a call mode, a recording mode, and a voice recognition mode. The received audio signal may be further stored in the memory 730. In some embodiments, the audio component 760 further includes a speaker to output audio signals.

The I/O interface 770 provides an interface for the processing component 740 and peripheral interface modules, such as a keyboard, a click wheel, buttons, and the like. The buttons may include, but are not limited to, a home button, a volume button, a starting button, and a locking button.

Fig. 8 is a flow chart showing a method for controlling photosensitivity according to an illustrative embodiment of the present disclosure. In the present embodiment, as shown in Fig. 7, the method for controlling the photosensitivity being used in the photosensitive control unit inside a terminal is taken as an example. The method includes the following steps.

In step 801, an enabling signal is sent to the control line in the *i*^{th} row, for controlling the photosensitive devices in the *i*^{th} row to communicate with the data line.

The enable signal is configured to control the photosensitive device in the *i*^{th} row to communicate with the data line. The photosensitive control unit sends the enabling signal to the control line in the *i*^{th} row of the control circuit. With the enabling signal, the photosensitive devices in the *i*^{th} row are communicated with the data line of the control circuit.

For example, as shown in Fig. 5, it is assumed that the control circuit includes four columns of the data lines 41, three rows of the control lines 42, and four photosensitive devices 33 in each row (i.e., 12 photosensitive devices 33 in total). When the photosensitive control unit sends the enabling signal to the control line 42 in the first row, four switches 45 in the first row are all in an ON state and four photosensitive devices 33 in the first row are communicated with the corresponding data line 41, respectively.

In step 802, a photosensitive signal collected by the photosensitive devices in the *i*^{th} row is obtained via the data line.

The photosensitive control unit obtains the photosensitive signal collected by the photosensitive devices in the *i*^{th} row via the data line. After being collected by the photosensitive devices, the photosensitive signal is transmitted to the photosensitive control unit in the case of communicating with the data line.

For example, as shown in Fig. 5, it is assumed that the control circuit includes four columns of the data lines 41, three rows of the control lines 42, and four photosensitive devices 33 in each row (i.e., 12 photosensitive devices 33 in total). After four photosensitive devices 33 in the first row are communicated with the data line 41, the photosensitive control unit may obtain the photosensitive signals collected by four photosensitive devices 33 via four columns of the data lines 41.

The photosensitive signal obtained by the photosensitive control unit is an analog signal. The analog signal is converted to a digital signal by an analog-digital converter, and the digital signal is stored in a memory.

In step 803, in the case that *i* is less than *b, i* is set as *i*+1 and the enabling signal is resent to the control line in the *i*^{th} row.

*i* represents the row number of the control line; and *b* represents the total number of rows. In the case that *i* is less than *b, i* is set as *i*+1 and the photosensitive control unit sends the enabling signal to the control line in the *i*+1^{th} row; and in the case that *i*=*b,* step 804 is performed.

For example, as shown in Fig. 4, it is assumed that the control circuit includes eight rows of the control lines. In the case that the photosensitive control unit sends the enabling signal to the control line in the third row for a predetermined time period, i.e., *i*=3<8, *i* is set as 4 and the enabling signal is sent to the control line in the fourth row and then row-by-row until the enabling signal is sent to the control line in the eighth row. That is, the photosensitive control unit sends the enabling signal to the control line row-by-row at intervals of the predetermined time period.

In step 804, in the case that *i* equals to *b, i* is set as 1 and the enabling signal is resent to the control line in the *i*^{th} row.

In the case that *i* equals to *b, i* is set as 1 and the photosensitive control unit sends the enabling signal to the control line in the first row. That is the enabling signal is sent to the control line again from the first row after the photosensitive control unit has sent the enabling signal to all rows of the control lines.

Step 801 is performed again after completing step 804, i.e., steps 801 to 804 are performed circularly. In the case that *i* is of an initial value of 1, the enabling signal is sent to the control lines row-by-row from the first row until the last row, so as to collect the photosensitive signal corresponding to a current frame. Subsequently, it is repeated that the enabling signal is sent to the control lines row-by-row from the first row to the last row, so as to collect the photosensitive signal corresponding to a next frame.

Above all, with the method for controlling the photosensitivity provided by embodiments of the present disclosure, the photosensitive control unit sends the enabling signal to the control lines in the control circuit row-by-row continuously, so that the photosensitive device in the control circuit communicates with the data line; obtains the photosensitive signal via the control line in the ON state; and processes the photosensitive signal, so as to integrate the camera function into the OLED panel, such that a front panel of the terminal may have the displaying function and the camera function at the same time even if merely provided with the OLED panel, thereby enhancing integral consistency and aesthetics of the terminal.

## Claims

1. An organic light emitting display, OLED, panel, comprising:
an array substrate (110);
an OLED layer (120) disposed on the array substrate;
a photosensitive device array (330) disposed between the array substrate and the OLED layer wherein the photosensitive devices of the photosensitive device array (330) are provided in the array substrate; and
a control circuit connected to the photosensitive device array, wherein the array substrate comprises m×n pixel units, each pixel unit comprises K pixel sub-units, the pixel sub-unit comprises a thin-film transistor (TFT) region and a non-TFT region; and the photosensitive device array comprises a×b photosensitive devices, each photosensitive device corresponds to one pixel sub-unit, a position in which at least one photosensitive device is present is located at the non-TFT region of a corresponding pixel sub-unit, a position in which the photosensitive device is present is located above a region of a corresponding sub-pixel unit, wherein **a≤K×m** and **b≤n.**

2. The OLED panel according to claim 1, wherein
the photosensitive devices in the photosensitive device array correspond to the pixel sub-units in the array substrate in a one-to-one manner, wherein *a*=*K*×*m* and *b=n;* or
the photosensitive device array is located at a partial region of the array substrate, the photosensitive devices in the photosensitive device array correspond to the pixel sub-units in the partial region in a one-to-one manner, wherein *a<K*×*m* and *b<n;* or *a<K*×*m* and *b*=*n;* or *a*=*K*×*m* and *b<n.*

3. The OLED panel according to any one of claims 1 to 2, wherein
the control circuit comprises a plurality of data lines in *a* columns and a plurality of control lines in *b* rows;
each row of the plurality of control lines is connected to the plurality of data lines in *a* columns via switches 45 in the number of *a*, respectively; and
a control terminal of each switch is connected to the control line, a first connecting terminal of each switch is connected to a corresponding photosensitive device, and a second connecting terminal of each switch is connected to a corresponding data line.

4. The OLED panel according to any one of claims 1 to 3, wherein each photosensitive device is provided with a lens (58) at a photosensitive side.

5. The OLED panel according to any one of claims 1 to 4, further comprising:
a glass substrate (130) disposed on the OLED layer;
a polarizer (140) disposed on the glass substrate; and
a lens (58) disposed on the polarizer.

6. A terminal, comprising an organic light emitting display (OLED) panel (710) according to any one of claims 1 to 5.

7. The terminal according to claim 6, wherein
the OLED panel is the OLED panel according to claim 6; and
the terminal further comprises a photosensitive control unit (720) connected to each data line and each control line.

8. A method for controlling photosensitivity, for use in a photosensitive control unit connected to an organic light emitting display (OLED) panel according to claim 3, comprising:
sending an enabling signal to a control line in the *i*^{th} row, for controlling a photosensitive device in the *i*^{th} row to communicate with a data line;
obtaining a photosensitive signal collected by the photosensitive devices in the *i*^{th} row via the data line;
setting *i* =*i*+1 and resending the enabling signal to the control line in the *i*^{th} row in the case that *i* is less than *b;* and
setting *i*=1 and resending the enabling signal to the control line in the *i*^{th} row in the case that *i* equals to *b.*

9. A program product having stored therein instructions that, when executed by one or more processors of a terminal comprising an organic light emitting display (OLED) panel according to any one of claims 1 to 5, causes the terminal to perform a method for controlling photosensitivity, for use in a photosensitive control unit connected to the OLED panel, the method comprising:
sending an enabling signal to a control line in the *i*^{th} row, for controlling a photosensitive device in the *i*^{th} row to communicate with a data line;
obtaining a photosensitive signal collected by the photosensitive devices in the *i*^{th} row via the data line;
setting *i* =*i*+1 and resending the enabling signal to the control line in the *i*^{th} row in the case that *i* is less than *b;* and
setting *i*=1 and resending the enabling signal to the control line in the *i*^{th} row in the case that *i* equals to *b.*

## Patentansprüche

1. Organisches Licht emittierendes Anzeige-, OLED-, Feld, das umfasst:
ein Array-Substrat (110);
eine OLED-Schicht (120), die auf dem Array-Substrat angeordnet ist;
ein lichtempfindliches Vorrichtungs-Array (330), das zwischen dem Array-Substrat und der OLED-Schicht angeordnet ist, wobei die lichtempfindlichen Vorrichtungen des lichtempfindlichen Vorrichtungs-Arrays (330) in dem Array-Substrat bereitgestellt sind; und
eine Steuerschaltung, die mit dem lichtempfindlichen Vorrichtungs-Array verbunden ist, wobei das Array-Substrat mxn Pixeleinheiten umfasst, wobei jede Pixeleinheit K Pixel-Teileinheiten umfasst, wobei die Pixel-Teileinheit einen Dünnfilmtransistor- (TFT-) Bereich und einen Nicht-TFT-Bereich umfasst; und das lichtempfindliche Vorrichtungs-Array axb lichtempfindliche Vorrichtungen umfasst, wobei jede lichtempfindliche Vorrichtung einer Pixel-Teileinheit entspricht, eine Position, in der mindestens eine lichtempfindliche Vorrichtung anwesend ist, an dem Nicht-TFT-Bereich der entsprechenden Pixel-Teileinheit liegt, eine Position, in der die lichtempfindliche Vorrichtung anwesend ist, oberhalb eines Bereichs einer entsprechenden Pixelteileinheit liegt, wobei *a<K*×*m* und b≤n.

2. OLED-Feld nach Anspruch 1, wobei
die lichtempfindlichen Vorrichtungen in dem lichtempfindlichen Vorrichtungs-Array eins zu eins den Pixel-Teileinheiten in dem Array-Substrat entsprechen, wobei *a*=*K*×*m* und *b*=*n;* oder
die lichtempfindliche Vorrichtung in einem Teilbereich des Array-Substrats liegt, wobei die lichtempfindlichen Vorrichtungen in dem lichtempfindlichen Vorrichtungs-Array eins zu eins den Pixel-Teileinheiten in dem Teilbereich entsprechen, wobei *a<Kxm* und *b<n;* oder *a<Kxm* und *b*=*n;* oder *a*=*K*×*m* und *b<n.*

3. OLED-Feld nach einem der Ansprüche 1 bis 2, wobei
die Steuereinheit eine Vielzahl von Datenzeilen in *a* Spalten und eine Vielzahl von Steuerzeilen in *b* Reihen umfasst;
jede Reihe der Vielzahl von Steuerzeilen mit der Vielzahl von Datenzeilen jeweils in *a* Spalten über Umschalter 45 in der Anzahl von *a* verbunden ist; und
eine Steuerklemme jedes Umschalters mit der Steuerleitung verbunden ist, eine erste Verbindungsklemme jedes Umschalters mit einer entsprechenden lichtempfindlichen Vorrichtung verbunden ist, und eine zweite Verbindungsklemme jedes Umschalters mit einer entsprechenden Datenleitung verbunden ist.

4. OLED-Feld nach einem der Ansprüche 1 bis 3, wobei jede lichtempfindliche Vorrichtung mit einer Linse (58) an einer lichtempfindlichen Seite bereitgestellt ist.

5. OLED-Feld nach einem der Ansprüche 1 bis 4, das weiter umfasst:
ein Glassubstrat (130), das auf der OLED-Schicht angeordnet ist;
einen Polarisator (140), der auf dem Glassubstrat angeordnet ist; und
eine Linse (58), die auf dem Polarisator angeordnet ist.

6. Endgerät, das ein organisches Licht emittierendes Anzeige- (OLED-) Feld (710) nach einem der Ansprüche 1 bis 5 umfasst.

7. Endgerät nach Anspruch 6, wobei
das OLED-Feld das OLED-Feld nach Anspruch 6 ist; und
das Endgerät weiter eine lichtempfindliche Steuereinheit (720) umfasst, die mit jeder Datenleitung und jeder Steuerleitung verbunden ist.

8. Verfahren zum Steuern von Lichtempfindlichkeit zur Verwendung in einer lichtempfindlichen Steuereinheit, die mit einem organisches Licht emittierenden Anzeige- (OLED-) Feld nach Anspruch 3 verbunden ist, das umfasst:
Senden eines Aktivierungssignals zu einer Steuerleitung in der *i-ten* Reihe zum Steuern einer lichtempfindlichen Vorrichtung in der *i-ten* Reihe, um mit einer Datenleitung zu kommunizieren;
Erhalten eines lichtempfindlichen Signals, das von den lichtempfindlichen Vorrichtungen in der *i-ten* Reihe gesammelt wird, über die Datenleitung;
Einstellen von *i*=*i+1* und erneutes Senden des Aktivierungssignals zu der Steuerleitung in der *i-ten* Reihe in dem Fall, dass *i* kleiner als *b* ist; und
Einstellen von *i*=*1* und erneutes Senden des Aktivierungssignals zu der Steuerleitung in der *i-ten* Zeile in dem Fall, dass *i* gleich *b* ist.

9. Programmprodukt, in dem Anweisungen gespeichert sind, die, wenn sie von einem oder mehreren Prozessoren eines Endgeräts, das ein organisches Licht emittierendes Anzeige- (OLED-) Feld nach einem der Ansprüche 1 bis 5 umfasst, ausgeführt wird, das Endgerät veranlasst, ein Verfahren zum Steuern von Lichtempfindlichkeit zur Verwendung in einer lichtempfindlichen Steuereinheit, die mit dem OLED-Feld verbunden ist, auszuführen, wobei das Verfahren umfasst:
Senden eines Aktivierungssignals zu einer Steuerleitung in der *i-ten* Reihe zum Steuern einer lichtempfindlichen Vorrichtung in der *i-ten* Reihe, um mit einer Datenleitung zu kommunizieren;
Erhalten eines lichtempfindlichen Signals, das von den lichtempfindlichen Vorrichtungen in der *i-ten* Reihe über die Datenleitung gesammelt wird;
Einstellen von *i*=*i*+1 und erneutes Senden des Aktivierungssignals zu der Steuerleitung in der *i-ten* Reihe in dem Fall, dass *i* kleiner als *b* ist; und
Einstellen von *i*=*1* und erneutes Senden des Aktivierungssignals zu der Steuerleitung in der *i-ten* Reihe in dem Fall, dass *i* gleich *b* ist.

## Revendications

1. Panneau à affichage électroluminescent organique, OLED, comprenant :
un substrat de réseau (110) ;
une couche OLED (120) disposée sur le substrat de réseau ;
un réseau de dispositifs photosensibles (330) disposé entre le substrat de réseau et la couche OLED, dans lequel les dispositifs photosensibles du réseau de dispositifs photosensibles (330) sont prévus dans le substrat de réseau ; et
un circuit de commande connecté au réseau de dispositifs photosensibles, dans lequel le substrat de réseau comprend m x n unités de pixel, chaque unité de pixel comprend K sous-unités de pixel, la sous-unité de pixel comprend une région de transistor à film mince (TFT) et une région de non-TFT; et le réseau de dispositifs photosensibles comprend a x b dispositifs photosensibles, chaque dispositif photosensible correspond à une sous-unité de pixel, une position dans laquelle au moins un dispositif photosensible est présent est située au niveau de la région de non-TFT d'une sous-unité de pixel correspondante, une position dans laquelle le dispositif photosensible est présent est située au-dessus d'une région d'une unité de sous-pixel correspondante, dans lequel a ≤ K x m et b ≤n.

2. Panneau OLED selon la revendication 1, dans lequel
les dispositifs photosensibles dans le réseau de dispositifs photosensibles correspondent aux sous-unités de pixel dans le substrat de réseau d'une manière biunivoque, dans lequel *a* = *K x m* et *b* = *n ;* ou
le réseau de dispositifs photosensibles est situé au niveau d'une région partielle du substrat de réseau, les dispositifs photosensibles dans le réseau de dispositifs photosensibles correspondent aux sous-unités de pixel dans la région partielle d'une manière biunivoque, dans lequel *a < K x m et b < n ;* ou *a < K x m* et *b* = *n ;* ou *a* = *K x m* et *b < n.*

3. Panneau OLED selon l'une quelconque des revendications 1 à 2, dans lequel
le circuit de commande comprend une pluralité de lignes de données dans *a* colonnes et une pluralité de lignes de commande dans *b* rangées ;
chaque rangée de la pluralité de lignes de commande est connectée à la pluralité de lignes de données dans *a* colonnes par l'intermédiaire de commutateurs 45 dans le nombre de *a*, respectivement ; et
une borne de commande de chaque commutateur est connectée à la ligne de commande, une première borne de connexion de chaque commutateur est connectée à un dispositif photosensible correspondant, et une seconde borne de connexion de chaque commutateur est connectée à une ligne de données correspondante.

4. Panneau OLED selon l'une quelconque des revendications 1 à 3, dans lequel chaque dispositif photosensible est muni d'une lentille (58) sur un côté photosensible.

5. Panneau OLED selon l'une quelconque des revendications 1 à 4 comprenant en outre :
un substrat de verre (130) disposé sur la couche OLED ;
un polariseur (140) disposé sur le substrat de verre ; et
une lentille (58) disposée sur le polariseur.

6. Terminal, comprenant un panneau à affichage électroluminescent organique (OLED) (710) selon l'une quelconque des revendications 1 à 5.

7. Terminal selon la revendication 6, dans lequel
le panneau OLED est le panneau OLED selon la revendication 6 ; et
le terminal comprend en outre une unité de commande photosensible (720) connectée à chaque ligne de données et à chaque ligne de commande.

8. Procédé de commande de photosensibilité, destiné à être utilisé dans une unité de commande photosensible connectée à un panneau à affichage électroluminescent organique (OLED) selon la revendication 1, comprenant les étapes consistant à :
envoyer un signal d'activation à une ligne de commande dans la *i*^{ème} rangée, pour commander un dispositif photosensible dans la *i*^{ème} rangée pour communiquer avec une ligne de données ;
obtenir un signal photosensible recueilli par les dispositifs photosensibles dans la *i*^{ème} rangée via la ligne de données ;
régler *i* = *i* + 1 et renvoyer le signal d'activation à la ligne de commande dans la *i*^{ème} rangée dans le cas où *i* est inférieur à *b* ; et
régler *i* = 1 et renvoyer le signal d'activation à la ligne de commande dans la *i*^{ème} rangée dans le cas où *i* est égal à *b*.

9. Produit de programme dans lequel sont stockées des instructions qui, lorsqu'elles sont exécutées par un ou plusieurs processeurs d'un terminal comprenant un panneau à affichage électroluminescent organique (OLED) selon l'une quelconque des revendications 1 à 5, amènent le terminal à exécuter un procédé pour commander la photosensibilité, pour une utilisation dans une unité de commande photosensible connectée au panneau OLED, le procédé comprenant les étapes consistant à :
envoyer un signal d'activation à une ligne de commande dans la *i*^{ème} rangée, pour commander un dispositif photosensible dans la *ième* rangée pour communiquer avec une ligne de données ;
obtenir un signal photosensible recueilli par les dispositifs photosensibles dans la *i*^{ème} rangée via la ligne de données ;
régler *i* = *i* + 1 et renvoyer le signal d'activation à la ligne de commande dans la *i*^{ème} rangée dans le cas où *i* est inférieur à *b* ; et
régler *i* = 1 et renvoyer le signal d'activation à la ligne de commande dans la *i*^{ème} rangée dans le cas où *i* est égal à *b*.
